# EUROPÄISCHE PATENTSCHRIFT

(11) **EP 1 460 438 B1**
(45) Veröffentlichungstag und Bekanntmachung des Hinweises auf die Patenterteilung: **02.06.2010**
(21) Anmeldenummer: 04001869.9
(22) Anmeldetag: 29.01.2004
(51) Int. Cl.: G01R 21/06

(54) **Modularer elektronischer Elektrizitätszähler**
Modular electricity meter
Compteur d'électricité modulaire

(30) Priorität: 15.03.2003 DE 10311441
(43) Veröffentlichungstag der Anmeldung: 22.09.2004
(73) Patentinhaber: EMH Elektrizitätszähler GmbH & Co KG, 19243 Wittenburg (DE)
(72) Erfinder: Malek, Norbert, 21438 Thieshope (DE)
(74) Vertreter: Hauck Patent- und Rechtsanwälte

(56) Entgegenhaltungen:
- EP-A- 0 365 216
- EP-A- 0 670 498
- EP-A- 0 718 635
- WO-A-03/012462
- DE-U1- 20 120 947
- GB-A- 2 183 049
- GB-A- 2 225 436
- US-A- 3 916 310
- US-A- 4 466 039
- US-A1- 2001 045 821

## Beschreibung

Die Erfindung bezieht sich auf einen elektronischen Elektrizitätszähler.

Heutige Elektrizitätszähler arbeiten mit einem Stromsensor, der z. B. als Stromwandler ausgeführt ist, und die Meßwerte für Strom und Spannung werden in ein elektronisches Zählermodul gegeben, in welchem die gemessenen Werte gespeichert und gegebenenfalls angezeigt werden. Die Eichgültigkeitsdauer von elektronischen Elektrizitätszählern ist zeitlich begrenzt. Zur Überprüfung ist der Zähler auszubauen bzw. auszuwechseln. Hierfür muss gegebenenfalls der Versorgungsanschluss des Stromabnehmers spannungslos geschaltet werden.

Das Eichgesetz erlaubt nicht, die Funktionen eines Elektrizitätszählers durch ein Software-Update zu modifizieren oder Software-Fehler zu korrigieren. Auch hierfür ist ein Ein- und Ausbau des Elektrizitätszählers erforderlich.

Elektrizitätszähler, die mit sogenannten passiven Stromwandlern arbeiten, sind mit Fehlern behaftet. So ist etwa der Innenwiderstand von der Temperatur abhängig. Außerdem können Phasenfehler auftreten sowie ein Einfluss durch die magnetischen Eigenschaften des Kerns des Stromwandlers.

Direkt an das Versorgungsnetz angeschlossene Elektrizitätszähler sind auch mit sogenannten Gleichanteilen des Verbraucherstroms belastet. Für die Genauigkeit des Elektrizitätszählers ist von Bedeutung, dass durch Gleichanteile keine unzulässig hohen Zusatzfehler auftreten.

Aus EP-A-0 718 635 und EP-A-0 670 498 ist bekannt geworden, bei elektronischen Elektrizitätszählern zur Strommessung Stromwandler zu verwenden, wobei auf den jeweiligen Kern des jeweiligen Stromwandlers eine mit einem Bürdenwiderstand in Reihe liegende Kompensationswinklung aufgebracht ist, die über jeweils einen mit der Sekundärwinklung verbundenen Regler so betrieben ist, dass der magnetische Fluss im Kern annähernd Null ist und die an dem jeweiligen Bürdenwiderstand liegende Spannung zur Bestimmung des Stroms in eine Messvorrichtung gegeben wird.

Aus WO 03/012462 A ist bekannt geworden, einen Stromwandler enthaltenden Stromsensor in einem Modul unterzubringen und mit diesem Modul über eine Steckverbindung ein Messmodul zu koppeln.

Aus EP-A-0 365 216 ist ein Stromwandler für größere Ströme bekannt geworden. Aus US 3,916,310 ist ein Stromwandler für Elektrizitätszähler bekannt geworden, der gleichfalls eine Kompensationsschaltung aufweist, um z.B. Temperaturschwankungen zu kompensieren. Eine ähnliche Kompensation schlägt GB-A-2 225 436 vor.

Der Erfindung liegt die Aufgabe zugrunde, einen elektronischen Elektrizitätszähler, insbesondere einen Haushaltszähler zu schaffen, der den Eichanforderungen in ausreichendem Maße gewachsen ist, jedoch mit geringem Aufwand herstellbar ist und insbesondere die Nachteile bekannter mit Stromwandler arbeitender Elektrizitätszähler vermeidet. Darüber hinaus liegt die Aufgabe zugrunde, bei Auswechslung des Zählermoduls die Stromversorgung des Stromabnehmers nicht unterbrechen zu müssen und den Stromsensor eingebaut lassen zu können.

Diese Aufgabe wird durch die Merkmale des Patentanspruchs 1 gelöst.

Bei dem erfindungsgemäßen Elektrizitätszähler ist wie im Stand der Technik auf den Kern der Stromwandler eine sogenannte Kompensationswicklung aufgebracht, die über einen mit der Sekundärwicklung des Stromwandlers verbundenen Regler so betrieben wird, dass der magnetische Fluss im Kern annähernd Null ist. Der Kompensationsstrom wird mit einem Bürdenwiderstand gemessen und entspricht der Größe des zu messenden Stroms. Dieser Spannungswert wird in das Messmodul zur Berücksichtigung der Messung der Energiemenge geleitet, welche bekanntlich das Produkt aus Strom und Spannung sowie Zeit ist.

Das Übersetzungsverhältnis von Primärstrom zu Sekundärstrom ist eindeutig an das Verhältnis von Primär- zu Kompensationswicklung gekoppelt. Änderungen der Kerneigenschaften oder des Übergangswiderstandes werden durch die Kompensationsregelung in einem weiten Bereich eliminiert. Die Regelung erfolgt typischerweise in der Form, dass an die Sekundärwicklung ein elektronischer Verstärker angeschlossen wird, dessen Ausgangssignal invertiert auf die Kompensationswicklung gegeben wird zwecks Erzeugung eines magnetischen Flusses im Kern, der dem Fluss entgegengesetzt ist, der durch die Primärwicklung erzeugt wird.

Die beschriebene Maßnahme hat den Vorteil, dass Temperaturänderungen keine Messfehler verursachen. Auch die für Stromwandler typischen Phasenfehler werden vermieden.

Bei der Erfindung ist der Kern so ausgelegt, dass er bei Auftreten eines Gleichanteils nicht in die magnetische Sättigung gelangt. Da die Wechselanteile kompensiert werden, braucht der Kern nur für eventuell auftretende Gleichanteile entsprechend ausgelegt zu werden, was die Abmessungen des Kerns reduziert.

Da der gemessene Strom nur durch die Anzahl der Windungen und von dem Bürdenwiderstand bestimmt wird, wird ein dem Laststrom proportionales Ausgangssignal erhalten. Dies hat eine geringe Exemplarstreuung zu Folge, was sich besonders vorteilhaft bei modularen Zählern auswirkt. Veränderungen des Ausgangssignals über eine längere Zeit sind nicht zu erwarten oder sind deutlich gcringcr als im Stand der Technik.

Der erfindungsgemäße Elektrizitätszähler ist in Modulbauweise ausgeführt. Bei dieser bilden Stromwandler und ein Steckerteil ein Modul, das ständig mit den Klemmen des Netzes verbunden bleiben kann. Das Messmodul weist seinerseits einen Steckverbindungsteil auf, das mit dem Steckverbindungsteil des ersten Moduls zusammengesteckt werden kann. Wird das Messmodul abgenommen, ist ein Abklemmen des Stromwandlermoduls vom Netz und damit eine Netzabschaltung nicht erforderlich, weil die Stromwandler für diesen Fall leerlauffest ausgelegt sind.

Das Stromwandlermodul ist zeitlich unbegrenzt beglaubigungsfähig oder verfügt zumindest über eine längere Eichgültigkeit als elektronische Zähler generell. Das Stromwandlermodul kann daher auf unbestimmte Dauer in der Installation verbleiben.

Ein Ausführungsbeispiel der Erfindung wird nachfolgend anhand einer Zeichnung näher erläutert.

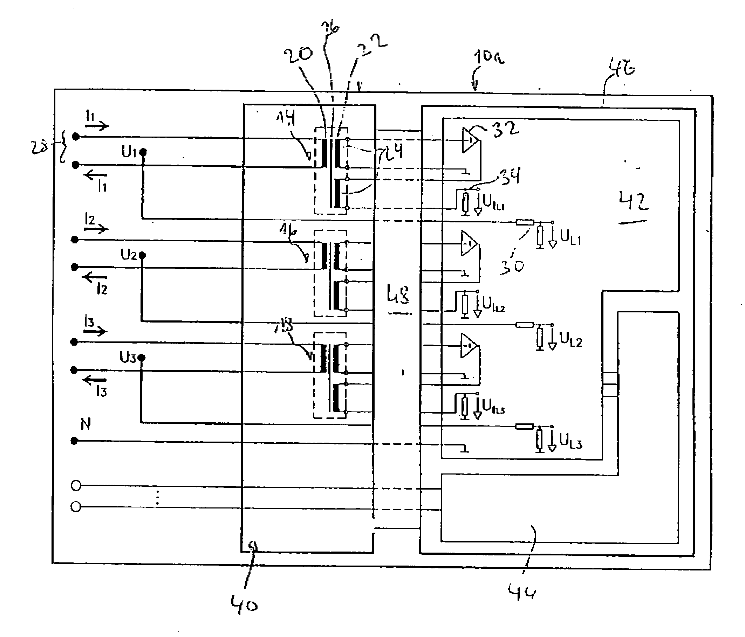

Die einzige Figur zeigt eine Ausführungsform eines elektronischen Elektrizitätszählers nach der Erfindung.

In der Figur ist ein Kasten 10a ein plombierbares Gehäuse für den darin aufgenommenen elektronischen Elektrizitätszähler. Das Gehäuse enthält ein Wendlermodul 40, in dem drei Stromwandler 14, 16, 18 angeordnet sind. Jeder Stromwandler weist eine Primärwicklung 20, eine Sekundärwicklung 22, eine Kompensationswicklung 24 und einen Kern 26 auf (dies ist nur im Hinblick auf den Stromwandler 14 gezeigt). Die Primärwicklung 20 ist wie üblich mit den Klemmen der Netzversorgung verbunden, wie bei 28 angedeutet. Mit den Klemmen ist ein Spannungsteiler 30 verbunden zur Ermittlung der Netzspannung U_{L}. Diese Spannung ist bekanntlich eine Netzgröße für die Ermittlung des Energieverbrauchs.

Sekundärwicklung 22 und Kompensationswicklung 24 sind auf den gleichen Kern gewickelt und haben z.B. die gleiche Anzahl von Windungen, beispielsweise 1000. Am Ausgang der Primärwicklung 22 ist ein invertierender Verstärker 32 angeschlossen, dessen Ausgang mit der Kompensationswicklung 24 verbunden ist. Ein Bürdenwiderstand 34 wandelt den Kompensationsstrom in eine Spannung U_{IL} um. Der Wert dieser Spannung entspricht der vom Zähler zu messenden Stromaufnahme, welcher ebenfalls in das nicht weiter beschriebene Messwerk des elektronischen Zählers eingegeben wird.

Die gezeigte Regelung des Stromwandlers ist derart, dass das Feld im Kern 26 auf annähernd Null geregelt wird. Dadurch ist die Spannung an der Sekundärwicklung 22 annähernd Null, und der Strom in der Kompensationswicklung 24 (Kompensationsstrom) entspricht dem aufgenommenen Strom, der über den Widerstand 34 gemessen wird.

Mit dem beschriebenen kompensierten Stromwandler ist es möglich, Temperatureinflüsse und Messfehler aufgrund von Phasenfehlern oder dergleichen zu minimieren. Darüber hinaus erhöht bei einem Gleichanteil in dem Messstrom der Wechselanteil nicht den Fluss im Kern 26, sondern dieser wird allein durch den Gleichanteil bestimmt. Wird der Kern so ausgelegt, dass er bei einem Gleichanteil nicht in die magnetische Sättigung gelangt, können Messfehler aufgrund von Sättigungsfehlern vermieden werden.

Wie beschrieben sind die Stromwandler 14 bis 16 in einem ersten Modul 40 angeordnet und der Regler (Verstärker) 32, der Widerstand 34 sowie der nicht weiter beschriebenen Messteile im Messmodul 42. Messmodul 42 und ein Zusatzmodul 44 für die Versorgung und den Betrieb des Zählermoduls 42 sind in einem gemeinsamen Gehäuse 46 angeordnet. Zu jedem Modul gehören im einzelnen nicht dargestellte Steckverbindungsteile für eine lösbare Steckverbindung der Module 40 und 42 bzw. 44 miteinander. Die Steckverbindung ist allgemein mit 48 bezeichnet.

Nach dem Öffnen des Gehäuses 10a kann das Gehäuse 46 ohne weiteres entfernt werden, z.B. zum Austausch mit einem anderen Zählcrmodul. Die Verbindung des Moduls 40 mit den Klemmen 28 kann jederzeit aufrechterhalten werden. Falls keine besonderen Vorkehrungen nötig sind, ist hierfür erforderlich, dass die Wandler 14 bis 18 leerlauffest sind.

Die beschriebene Anordnung hat den Vorteil, dass das Wandlermodul 40, das nahezu zeitlich unbegrenzt betrieben werden darf, ohne einer Überprüfung oder Neueichung zu bedürfen, mit dem Netz verbunden bleiben kann, wenn das Zählermodul 42 getestet oder ausgetauscht werden muss.

## Patentansprüche

1. Elektronischer Elektrizitätszähler, insbesondere Haushaltszähler, mit einem einzigen Stromwandler je Phase, der jeweils eine Primär- und eine Sekundärwicklung sowie einen Kern aufweist und einem elektronischen Meßmodul, wobei auf den jeweiligen Kern (26) des jeweiligen Stromwandlers (14, 16, 18) eine mit einem Bürdenwiderstand in Reihe liegende Kompensationswicklung (24) aufgebracht ist, die über jeweils einen mit der Sekundärwicklung (22) verbundenen Regler (32) so betrieben ist, daß der magnetische Fluß im Kern (26) annähernd Null ist, und daß die an dem jeweiligen Bürdenwiderstand (34) liegende Spannung zur Bestimmung des Stroms in das Meßmodul (42) eingegeben wird, **dadurch gekennzeichnet, daß** der Kern (26) des jeweiligen Stromwandlers (14, 16, 18) so ausgelegt ist, daß bei einem Gleichanteil im Primärstrom der Kern (26) nicht in die Sättigung getrieben wird und die Stromwandler (14 bis 18) leerlauffest und Teil eines Stromwandlermoduls (40) sind, das einen Steckverbinderteil aufweist und das Meßmodul (42) ebenfalls einen Steckverbinderteil aufweist und den Regler (32) enthält.

## Claims

1. Electronic electricity meter, particularly household kilowatt-hour meter, with one single current transformer for each phase, which has one primary and one secondary winding, respectively, as well as one core, and with an electronic measuring module, wherein a compensation winding (24), connected in series with a load resistor, is applied to the respective core (26) of the respective current transformer (14, 16, 18), said compensation winding (24) being operated via one controller (32), respectively, connected with the secondary winding (22), such that the magnetic flux in the core (26) is approximately zero, and the voltage across the respective load resistor (34) is input into the measuring module (12, 42) for the determination of the current, **characterized in that** the core (26) of the respective current transformer (14, 16, 18) is dimensioned such that the core (26) is not driven into saturation upon a dc portion in the primary current, and the current transformers (14 to 18) are no-load proof and are part of a current transformer module (40) which has a plug-and-socket portion, and that the measuring module (42) has a plug-and-socket portion as well and contains the controller (32).

## Revendications

1. Compteur d'électricité modulaire, en particulier compteur domestique, avec un seul transformateur d'intensité par phase qui présente respectivement un enroulement primaire et un enroulement secondaire ainsi qu'un noyau, et un module de mesure électronique, un enroulement de compensation (24) monté en série avec une résistance de charge étant placé sur le noyau (26) respectif du transformateur d'intensité respectif (14, 16, 18), enroulement qui est mis en oeuvre via respectivement un régulateur (32) connecté à l'enroulement secondaire (22) de sorte que le flux magnétique dans le noyau (26) est quasiment nul, et de sorte que la tension au niveau de la résistance de charge (34) respective est entrée pour déterminer le courant dans le module de mesure (42), **caractérisé en ce que** le noyau (26) du transformateur d'intensité respectif (14, 16, 18) est conçu de sorte que, pour une composante continue dans le courant primaire, le noyau (26) n'est pas mis en oeuvre à saturation et les transformateurs d'intensité (14 à 18) résistent à la marche à vide et font partie d'un module de transformateur d'intensité (40) qui présente une partie de raccord à fiche, et le module de mesure (42) présente également une partie de raccord à fiche et contient le régulateur (32).
